# EUROPEAN PATENT APPLICATION

(11) **EP 4 151 299 A1**
(43) Date of publication of application: **22.03.2023**
(21) Application number: 22184606.6
(22) Date of filing: 13.07.2022
(51) Int. Cl.: B01D 21/00, B01D 46/00, F28F 3/12, H01L 21/48, H01L 23/367, H05K 7/20

(54) **FLUID CONTROL DEVICE AND METHOD**

(30) Priority: 20.07.2021 US 202117380832
(71) Applicant: Transportation IP Holdings, LLC, Norwalk, CT 06851 (US)
(72) Inventor: Murphy, Mark, Norwalk, 06851 (US); Vettuvazhy Puthenpurayil, Jain Raj, Norwalk, 06851 (US); Yammanuru, Rajendra, Norwalk, 06851 (US); Brown, Theodore, Norwalk, 06851 (US)
(74) Representative: Laufhütte, Dieter

(57) **Abstract**

A fluid control device includes a housing having plural surfaces defining a cavity within the housing. The housing includes an inlet to receive a fluid mixture and an outlet to direct the fluid mixture out of the housing. The fluid mixture includes a fluid combined with debris. A structure array is disposed within the cavity and includes plural structures. Each of the plural structures includes a first surface coupled with an internal surface of the housing and a second surface disposed a distance away from the internal surface of the housing. The structure array includes a first portion and a second portion. The first portion is configured to interfere with the fluid mixture to separate at least some of the debris from the fluid, and the second portion is configured to direct the fluid and at least some of the debris toward the outlet.

## Description

### BACKGROUND

### Technical Field.

The subject matter described relates to fluid control devices and methods.

### Discussion of Art.

Atmospheric fluids may be used within electrical and/or mechanical systems, such as to control a thermal energy of the systems. For example, electrical systems may be coupled with heat exchangers having a fluid control device, through which fluid may be directed through the heat exchanger to control a temperature of the electrical assemblies. As another example, fluids may be used within systems that may control or change characteristics of the fluid, such as compressors. The compressor may also include a filter or filter system at an inlet of the compressor to control movement of the fluid, such that some portions of the fluid may be directed through the compressor, and other portions may not be directed through the compressor. The electrical and/or mechanical system may be used onboard mobile systems, such as vehicles, aircraft, marine vessels, or within stationary systems such as wind-powered turbine, manufacturing machinery, power generating systems, or the like.

The fluid directed through the systems, however, may be a mixture of a fluid and some debris. For example, the debris may include particles, contaminants, dust, or other matter that may be mixed with the fluid. The fluid may be a liquid such as water, may be a gas such as atmospheric air, or optionally may be a liquid-gas mixture with debris combined therewith. One technical problem with fluid control devices, however, is that at least some of the debris combined with the fluid may separate from the fluid and may remain within the fluid control device. As a result, over time, the amount of debris may increase, causing the fluid control device to become clogged, causing the pressure of the fluid mixture moving within the device to be compromised. Operation of the electrical system may need to be stopped in order to clean the device to remove the debris build up within the fluid control device. As the amount of debris clogged within a fluid control device increases, characteristics of the fluid moving through the device (e.g., a pressure or pressure drop, velocity, direction of flow, or the like) may become compromised, resulting in a reduced efficiency of the electrical and/or mechanical system through which the fluid is directed.

### BRIEF DESCRIPTION

In one or more embodiments, a fluid control device includes a housing having plural surfaces defining a cavity within the housing. The housing includes an inlet configured to receive a fluid mixture and an outlet configured to direct the fluid mixture out of the housing. The fluid mixture includes a fluid combined with debris. A structure array is disposed within the cavity of the housing and includes plural structures. Each of the plural structures includes a first surface operably coupled with an internal surface of the housing and a second surface disposed a distance away from the internal surface of the housing. The structure array includes a first portion and a second portion. The first portion of the structure array is configured to interfere with the fluid mixture to separate at least some of the debris from the fluid, and the second portion of the structure array is configured to direct the fluid and at least some of the debris toward the outlet.

In one or more embodiments, a method includes directing a fluid mixture having a fluid combined with debris into a housing via an inlet. The housing includes plural surfaces defining a cavity within the housing. At least some of the debris is separated from the fluid with a first portion of a structure array disposed within the cavity as the fluid mixture moves within the first portion of the structure array. The structure array includes plural structures, and each of the plural structures includes an interface surface, a first surface operably coupled with an internal surface of the housing, and a second surface disposed a distance away from the internal surface of the housing. The fluid and at least some of the debris is directed through a second portion of the structure array toward an outlet of the housing.

In one or more embodiments, a system includes a fluid control device having a housing that includes plural surfaces defining a cavity within the housing. The housing includes an inlet configured to receive a fluid mixture and an outlet configured to direct the fluid mixture out of the housing. The inlet of the housing extends between a first end and a second end of the housing. The fluid mixture includes a fluid combined with debris. The fluid control device includes a structure array disposed within the cavity of the housing that includes a first portion and a second portion. The first portion of the structure array is configured to interfere with the fluid mixture to separate at least a portion of the debris from the fluid, and the second portion of the structure array is configured to direct the fluid and a portion of the debris toward the outlet. The system includes a passage fluidly coupled with the fluid control device. The passage extends between a passage inlet and a passage outlet. The passage outlet is fluidly coupled with the inlet of the housing. The passage outlet extends between the first end and the second end of the housing. The fluid mixture is configured to move in a first direction within the passage and the fluid mixture is configured to move in a second direction that is opposite the first direction within the cavity.

### BRIEF DESCRIPTION OF THE DRAWINGS

The inventive subject matter may be understood from reading the following description of non-limiting embodiments, with reference to the attached drawings, wherein below:
Figure 1 illustrates a panel assembly in accordance with one embodiment;
Figure 2 illustrates a cross-sectional view of the panel assembly of Figure 1;
Figure 3 illustrates a panel assembly in accordance with one embodiment;
Figure 4 illustrates a cross-sectional view of the panel assembly shown in Figure 3;
Figure 5 illustrates a panel assembly in accordance with one embodiment;
Figure 6 illustrates a top cross-sectional view of the panel assembly shown in Figure 5 in accordance with one embodiment;
Figure 7 illustrates a side cross-sectional view of the panel assembly shown in Figure 5 in accordance with one embodiment;
Figure 8 illustrates a partial side view of a structure of a fluid control device in accordance with one embodiment;
Figure 9 illustrates a partial top view of a structure array of a fluid control device in accordance with one embodiment;
Figure 10 illustrates a partial perspective view of a structure array of a fluid control device in accordance with one embodiment;
Figure 11 illustrates a side view of a structure of the structure array shown in Figure 10;
Figure 12 illustrates a performance graph of a system in accordance with one embodiment; and
Figure 13 illustrates a performance graph of a system in accordance with one embodiment.

### DETAILED DESCRIPTION

Embodiments of the subject matter described herein relate to systems having fluid control devices and methods that include directing a fluid mixture in different directions within the systems. The system may also be referred to as a panel assembly that includes a panel operably coupled with the fluid control device. One or more passages of the panel may direct the fluid mixture into the panel assembly, and may be fluidly coupled with a housing of the fluid control device. The housing includes plural surfaces defining a cavity, an inlet that receives the fluid mixture from the one or more passages of the panel, and an outlet to direct the fluid mixture out of the housing. In one or more embodiments, the inlet of the housing may extend a width between two surfaces of the housing, and the passage may extend the same width between the two surfaces of the housing. Optionally, the passage may have a width that is smaller or less than a width of the inlet of the housing of the fluid control device.

In one or more embodiments, the fluid control device may include a structure array disposed within the cavity, where a first portion of the structure array has a configuration (e.g., shape, size, orientation, or the like) that is different than a configuration of a second portion of the structure array. For example, the first portion may interfere with the fluid mixture to separate at least some of the debris from the fluid of the fluid mixture, and the second portion of the structure array may direct the fluid and some of the debris toward the outlet of the fluid control device. The fluid mixture may exchange thermal energy with one or more other fluids and/or surfaces of the thermal system to control a temperature of the thermal system.

The structure array may include plural structures. In one example, the structures may include a first surface coupled with an internal surface of the housing, and a second surface disposed a distance away from the internal surface of the housing. Optionally, the structures may have an alternative configuration, and may be coupled with the internal surface(s) of the housing via other orientations. The plural structures may include one or more interference surfaces disposed and extending between the first and second surfaces of each structure. For example, the interference surfaces may be angled or inclined such that the interference surfaces are disposed at increasing distances away from the internal surface of the housing at increasing distances away from the inlet of the housing. Optionally, one or more structures of the array may include two or more interference surfaces forming a step feature.

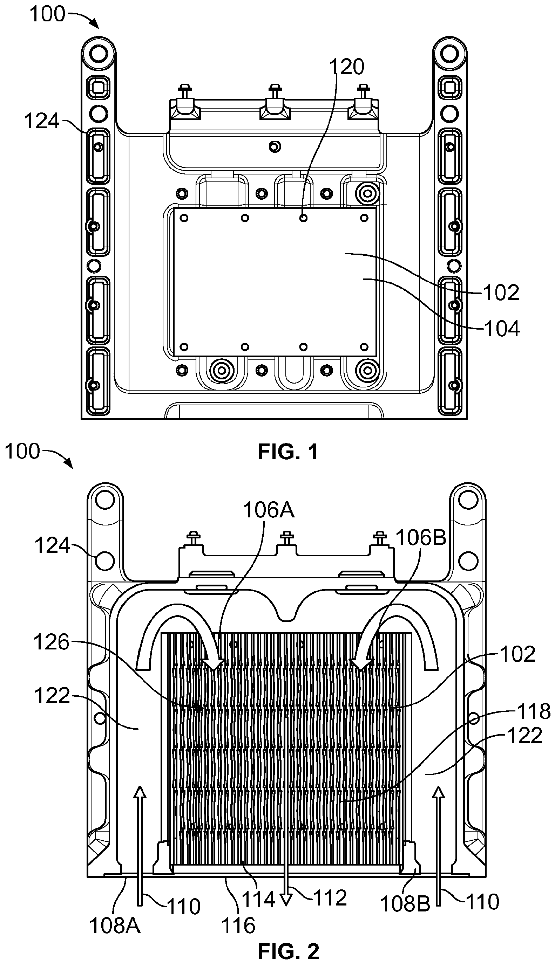

Figure 1 illustrates a panel assembly 100 in accordance with one embodiment. Figure 2 illustrates a cross-sectional view of the panel assembly of Figure 1. In one or more embodiments, the panel assembly may be an insulated gate bipolar transistor (IGBT) inverter, or may be an alternative electrical assembly such as a pulse gate drive transformer, a full pulse module gate drive, a metal oxide semiconductor field-effect transistor (MOSFET) such as a power MOSFET), or the like. The panel assembly may be coupled with a portable or moving system such as a vehicle system, a rail vehicle, a car, or other passenger vehicle, a mining vehicle, a bus, an aircraft (manned or unmanned, such as drones), agricultural equipment, or another off-highway vehicle, a truck, marine vessels, or the like. Optionally, the panel assembly may be coupled with non-vehicle alternative systems, such as a wind-powered turbine, manufacturing machinery, power generating systems, domestic or commercial cooling systems, personal appliances, or the like.

The panel assembly and the X-Y-Z coordinate system are used herein only for the purpose of explaining aspects of the subject matter and are not intended to limit the scope of the disclosure. In this regard, directional indicators such as "left" and "right," "front" and "back," and "top" and "bottom" are only used to indicate the relative positioning of two sides of the system along the X-direction, the Y-direction, and the Z-direction, respectively.

The panel assembly includes a panel 124 and a fluid control device 102 operably coupled with the panel. In the illustrated embodiment, the fluid control device is coupled with the panel via plural fasteners 120, but alternatively may be coupled with the panel via other coupling methods such as welding, adhesion, or other coupling components or features. The fluid control device includes a housing 104 with plural surfaces that define a cavity 118 within the housing. Figure 2 illustrates a cross-sectional view of the panel and the fluid control device.

In one embodiment, the fluid control device may control an amount of thermal energy transferred between the fluid control device and the panel and/or panel assembly. For example, the fluid control device may be referred to as a heat sink, a cooling device or system, or the like. In one or more embodiments, the fluid control device may control a temperature of the vehicle system or other non-vehicle system. In another embodiment, the fluid control device may control an amount of transfer of another energy (e.g., mechanical, electrical, radiation, or the like) between the fluid mixture within the fluid control device and another fluid or substance within one or more components of the panel assembly. Optionally, the fluid control device may be a filter or filter system that may control what portions of the fluid mixture may be directed through the fluid control device and/or through other portions of the panel assembly, and what portions of the fluid mixture may not be directed through the fluid control device, or may be directed through other portions of the panel assembly.

The panel includes inlets 108A, 108B disposed on either side of the fluid control device. A fluid mixture 110 is directed into the panel via the first inlets of the panel and through passages 122 of the panel in a first direction. In the illustrated embodiment of Figures 1 and 2, the passages are disposed between side surfaces of the panel and the fluid control device. For example, the passages may direct the fluid mixture from a location outside of the fluid control device and along a side portion of the fluid control device. The fluid mixture may be a fluid combined with debris. The fluid may be a gas, such as air, or a liquid such as a coolant. In one embodiment, the fluid may be atmospheric air that may be combined or mixed with debris with the atmospheric air.

The fluid mixture moves within the passages of the panel toward inlets 106A, 106B of the housing of the fluid control device. In the illustrated embodiment, the passages of the panel and the housing of the fluid control device are positioned such that the fluid mixture moves in a first direction within the passages of the panel, and is directed to move in a second direction that is substantially opposite the first direction within the cavity of the housing. For example, the fluid mixture turns about 180 degrees prior to the fluid mixture being directed into the inlets of the housing of the fluid control device. Optionally, the first direction may be tangential relative to the second direction, such that the fluid mixture may turn less than 180 degrees or more than 180 degrees to be directed into the inlets of the housing of the fluid control device.

The fluid control device includes a structure array 126 disposed within the cavity of the housing. The structure array may include one or more structures that control a direction of movement of the fluid mixture. For example, the structure array may include one or more passages, channels, or other structures that may change one or more characteristics of the fluid mixture such as, but not limited to, a direction of movement of the fluid mixture, a pressure of the fluid mixture, a velocity or flow rate, an amount of turbulence, an amount of the fluid mixture moving in one or more directions or toward one or more regions of the housing, an amount of energy (e.g., thermal, electrical, or the like) transferred between the fluid mixture and one or more surfaces of the housing, or the like. In one or more embodiments, the structure array may be manufactured of a metal alloy (e.g., aluminum, steel, copper, or the like), or a non-metallic material (e.g., a plastic material, composite, or the like).

The fluid mixture is directed out of the housing via an outlet 114 of the housing of the fluid control device, and is directed out of the panel via an outlet 116 of the panel. In one or more embodiments, as the fluid mixture moves between the inlets of the housing and the outlet of the housing, a portion of the debris may separate from the fluid. For example, a portion or some of the debris may interfere with one or more surfaces of the structure array and may separate from the fluid. The fluid mixture that is directed into the panel and into the fluid control device may have a first amount or percentage of debris combined with the fluid, and an outlet mixture 112 that is directed out of the fluid control device and out of the panel may have a second amount or a second percentage of debris combined with the fluid. For example, the first amount or first percentage of debris combined with the fluid to form the fluid mixture may be greater than the second amount or second percentage of debris combined with the fluid to form the outlet mixture. For example a portion of the debris may remain within the fluid control device.

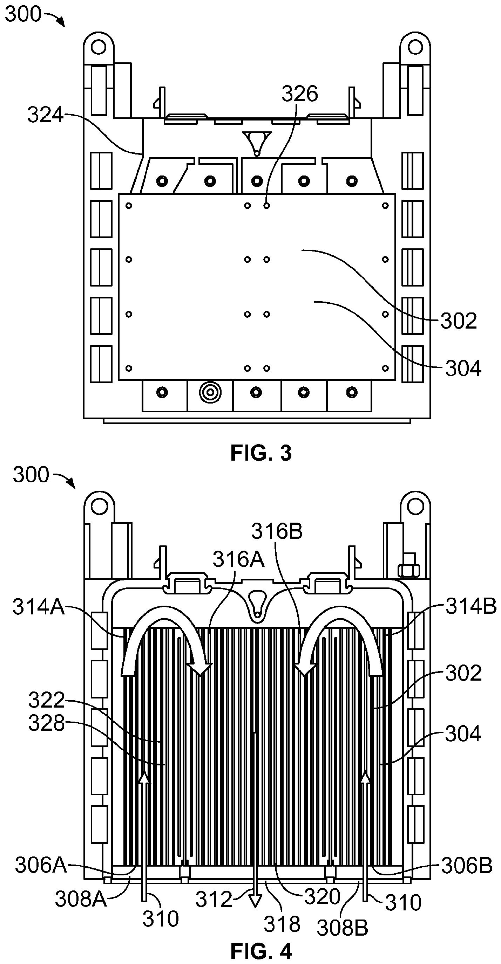

In one or more embodiments, the position of the fluid control device relative to the panel may change to control one or more flow characteristics of the fluid mixture within the fluid control device. For example, Figure 3 illustrates a panel assembly 300 in accordance with one embodiment, and Figure 4 illustrates a cross-sectional view of the panel assembly of Figure 3. The panel assembly includes a panel 324 and a fluid control device 302 operably coupled with the panel. In the illustrated embodiment, the fluid control device is coupled with the panel via plural fasteners 326, but may be coupled with the panel via other coupling methods.

The fluid control device includes a housing 304 with plural surfaces that define a cavity 322 within the housing. In the illustrated embodiment of Figure 3, the housing of the fluid control device is rotated relative to the housing of the fluid control device shown in Figures 1 and 2. Additionally, the housing of the fluid control device shown in Figures 3 and 4 has a size that is greater than a size of the housing of the fluid control device shown in Figures 1 and 2. In one embodiment, the panel assembly shown in Figures 3 and 4 may include two of the housings of the fluid control device shown in Figures 1 and 2. For example, the same housing of the panel assembly 100 may be used within the panel assembly 300, with the panel assembly 300 including two housings and the panel assembly 100 including a single housing that is rotated relative to the two housings of the panel assembly 300. Alternatively, the panel assembly 300 may include a fluid control device that includes a housing that is unique relative to the housing of the fluid control device of the panel assembly 100.

The panel includes inlets 308A, 308B that are fluidly coupled with first inlets 306A, 306B of the housing. A fluid mixture 310 is directed into the inlets of the panel and toward the inlets of the housing of the fluid control device. Alternative to the fluid control device shown in Figure 2, the inlets of the housing are positioned relative to the inlets of the panel such that the fluid mixture is directed in a first direction into the panel, and in the same first direction or substantially the same first direction, into the housing via the inlets. In one or more embodiments, the fluid mixture may be atmospheric air mixed or combined with debris. Alternatively, the fluid mixture may be an alternative gas or liquid combined with debris.

The fluid mixture moves within the housing toward first outlets 314A, 314B of the housing of the fluid control device. For example, the fluid mixture may be directed through a portion of the housing between the first inlets and the first outlets in a first direction. The fluid mixture may turn about 180 degrees subsequent to the fluid mixture being directed out of the first outlets, and prior to the fluid mixture being redirected back into the housing via second inlets 316A, 316B of the housing. Optionally, the cavity of the housing may be configured to direct the fluid mixture in different directions such that the fluid mixture may turn or rotate a distance less than 180 degrees, or more than 180 degrees to be directed into the second inlets of the housing.

In one or more embodiments, the fluid control device of the panel assembly shown in Figures 3 and 4 may be referred to as a dual pass fluid control device. For example, the fluid mixture may be directed through the fluid control device at least two times, such as in two different directions. For example, the dual pass fluid control device may direct the fluid mixture in a first direction as a first pass through the fluid control device, and may direct the fluid mixture in a different, second direction as a second pass through the fluid control device. Alternatively, the housing of the fluid control device may have an alternative configuration such that the fluid mixture may pass through the fluid control device more than two times (e.g., three times, such as a triple pass system), or less than two times (e.g., a single pass system, such as shown in Figures 1 and 2).

The housing of the fluid control device includes a structure array 328 disposed within the cavity of the housing. The structure array may include plural structures having uniform and/or unique shapes, sizes, orientations, or the like. The structures may interfere with the fluid mixture as the fluid mixture moves within the fluid control device to control one or more characteristics of the fluid mixture. For example, the structures may be positioned, arranged, orientated, sized, or the like, to control one or more characteristics such as, but not limited to, pressure, turbulence, flow rate or velocity, a direction of movement, or the like. Controlling the characteristics of the fluid mixture may control an amount of energy transferred between the fluid mixture and one or more surface of the housing. For example, the fluid mixture may transfer thermal energy with one or more surfaces of the panel assembly or other substances moving through the panel assembly to control a temperature of the panel assembly.

The fluid mixture is directed out of the housing via a second outlet 320 of the housing of the fluid control device, and is directed out of the panel via an outlet 318 of the panel. In one or more embodiments, as the fluid mixture moves between the first inlets of the housing and the second outlet of the housing, a portion of the debris combined with the fluid may separate from the fluid. For example, as the fluid mixture interferes with the structures of the structure array, at least some of the debris may separate from the fluid. The fluid mixture that is directed out of the fluid control device may have an amount of debris combined or mixed with the fluid that is less than an amount of debris that is combined or mixed with the fluid mixture that is directed into the fluid control device. For example, an outlet mixture 312 that is directed out of the fluid control device and out of the panel may have a different amount of debris combined with the fluid relative to the fluid mixture directed into the fluid control device. Additionally or alternatively, the outlet mixture may have one or more flow characteristics or thermal characteristics that are different than flow characteristics and/or thermal characteristics of the fluid mixture directed into the fluid control device. For example, the outlet mixture may have an amount of thermal energy that is greater than an amount of thermal energy of the fluid mixture directed into the fluid control device. Optionally, a pressure of the outlet mixture may be different than a pressure of the fluid mixture directed into the fluid control device.

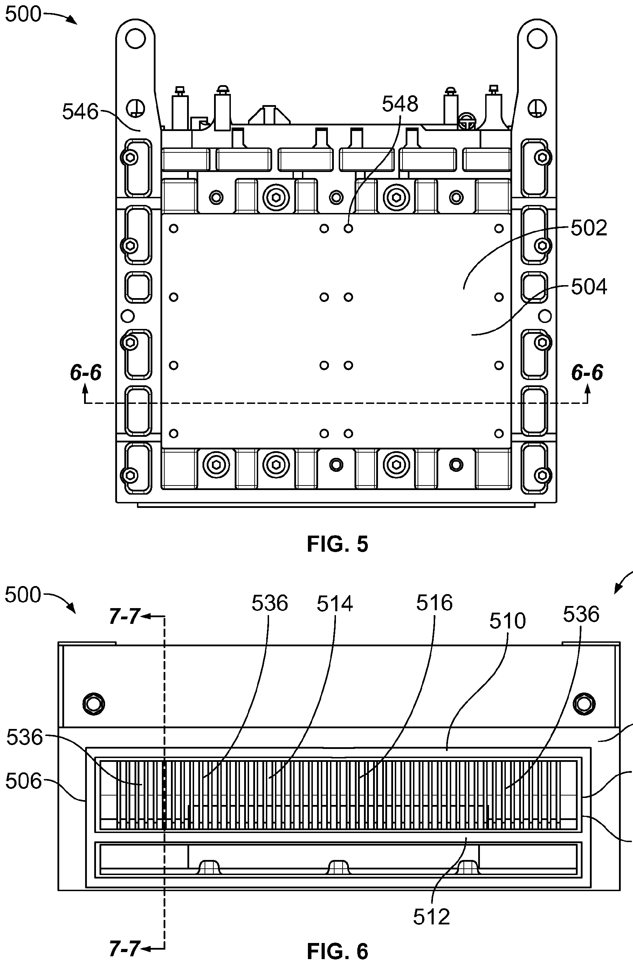

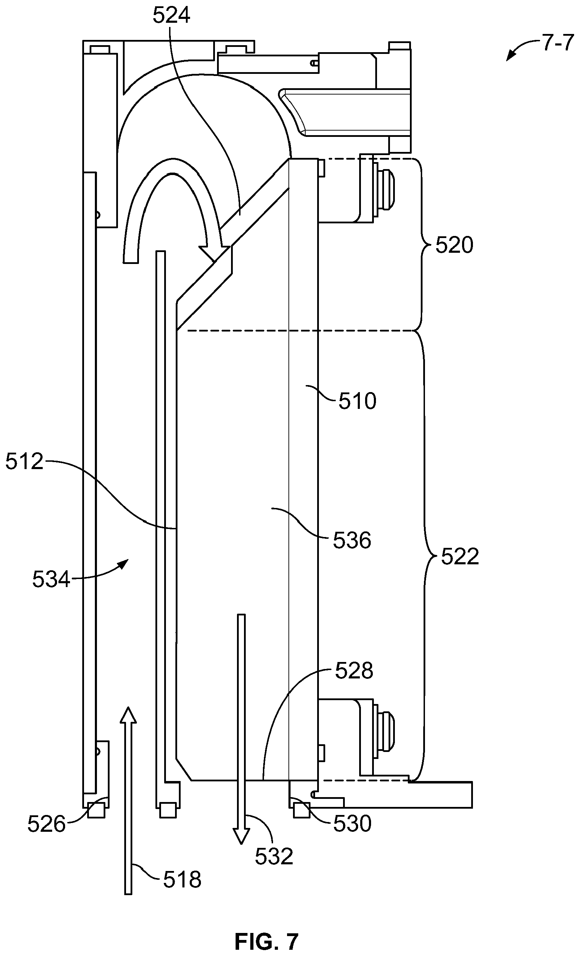

Optionally, the fluid control device may have an alternative configuration. For example, Figure 5 illustrates a panel assembly 500 in accordance with another embodiment of the subject matter described herein. Figure 6 illustrates a top cross-sectional view of the panel assembly, and Figure 7 illustrates a side cross-sectional view of the panel assembly shown in Figure 5. Like the panel assembly 300 shown in Figure 3, the panel assembly 500 includes a panel 546 and a fluid control device 502. The fluid control device includes a housing 504 that is operably coupled with the panel via plural fasteners 548. Optionally, the housing may be coupled with the panel via alternative coupling methods.

The housing of the fluid control device includes plural surfaces, such as surfaces 506, 508, 510, and 512 shown in Figures 6 and 7. The surfaces define a cavity 514 of the housing of the fluid control device. The housing includes an inlet 524 that is fluidly coupled with an inlet 526 of the panel via a panel passage 534. A fluid mixture 518 may be directed into the panel via the panel inlet, and may be directed out of the panel passage toward the inlet of the housing. The fluid mixture may be a fluid that is combined with or mixed with debris. The fluid may be a gas, a liquid, or a mixture of a gas and a liquid. In one embodiment, the fluid mixture may be atmospheric air that may be used to control a temperature or a thermal energy level within the panel assembly. Alternatively, the fluid mixture may be an alternative coolant fluid.

In one or more embodiments, the surface 506 may define a first end of the housing, and the surface 508 may define a second end of the housing. In the illustrated embodiment, the inlet of the housing extends between surfaces 506 and 508 (e.g., between the first and second ends of the housing) along a first direction. For example, a width of the inlet is substantially the same as a width of the housing of the fluid control device. Optionally, the width of the inlet may be less than or smaller than the width of the housing between the surfaces 506, 508. Optionally, the inlet may be positioned such that a center or substantial center of the inlet is aligned with a center axis (not shown) of the housing between the surfaces 506, 508. Optionally, a center of the inlet may be positioned closer to the surface 506 relative to the surface 508. Optionally, the inlet may have any alternative position, shape, or size. Additionally, a passage outlet of the panel passage extends between the surface 506 (e.g., the first end of the housing) and the surface 508 (e.g., the second end of the housing). For example, a width of the passage outlet between the surfaces 506, 508 may be substantially the same as the width of the inlet of the housing.

In one or more embodiments, the fluid control device of the panel assembly shown in Figures 5 through 7 may be referred to as a single pass fluid control device. For example, the fluid mixture may move through the fluid control device a single time, as opposed to the dual pass fluid control device shown in Figures 3 and 4, in which the fluid mixture is directed through the fluid control device at least two times.

Like the panel assembly 100 shown in Figures 1 and 2, the fluid control device of the panel assembly 500 is positioned such that the fluid mixture may turn about 180 degrees subsequent to the fluid mixture being directed through the panel passage, and prior to the fluid mixture being directed into the inlet of the housing. Optionally, the cavity of the housing may be configured to direct the fluid mixture in different directions such that the fluid mixture may turn or rotate a distance less than 180 degrees, or more than 180 degrees to be directed into the inlet of the housing. The fluid mixture is directed out of the housing via an outlet 528 of the housing of the fluid control device, and is directed out of the panel via an outlet 530 of the panel.

The fluid control device includes a structure array 516 that is disposed or positioned within the cavity of the housing. The structure array includes plural structures 536 that are positioned to interfere with the fluid mixture that moves within the cavity. In one or more embodiments, the structures of the structure array may form or create passages within the cavity to control a direction of movement of the fluid mixture. Optionally, the structures may be positioned, shaped, and sized to control a pressure of the fluid mixture at different locations or positions within the cavity. Optionally, the structures may be positioned, shaped, and sized to control other flow characteristics of the fluid mixture such as, but not limited to, a velocity or flow rate, turbulence, rotational forces, or the like.

In one or more embodiments, as the fluid mixture moves between the first inlets of the housing and the second outlet of the housing, a portion of the debris combined with the fluid may separate from the fluid. For example, as the fluid mixture interferes with the structures of the structure array, at least some of the debris may separate from the fluid. The fluid mixture that is directed out of the fluid control device may have an amount of debris combined or mixed with the fluid that is less than an amount of debris that is combined or mixed with the fluid mixture that is directed into the fluid control device. For example, an outlet mixture 532 that is directed out of the fluid control device and out of the panel may have a different amount of debris combined with the fluid relative to the fluid mixture directed into the fluid control device, may have one or more flow characteristics or thermal characteristics that are different than flow characteristics and/or thermal characteristics of the fluid mixture directed into the fluid control device, or the like.

In one or more embodiments, the structure array may be separated into two or more portions. For example, a first portion 520 may be disposed or positioned proximate the inlet of the housing, and a second portion may be disposed or positioned proximate the outlet of the housing. For example, the second portion of the structure array is downstream of the first portion of the structure array in the direction of movement of the fluid mixture through the fluid control device. The structures of the first portion of the structure array may have a shape, size, and/or configuration that is different than a shape, size, and/or configuration of the second portion of the structure array. For example, the first portion of the structure array may have one or more features that are designed to interfere with the fluid mixture, and the second portion of the structure array may have different features that are designed to control movement of the fluid mixture. The first portion of the structure array may be designed to interfere with the fluid mixture to separate some of the debris from the fluid, and the second portion of the structure array may be designed to control flow characteristics of the fluid mixture with the reduced amount of the debris within the fluid (e.g., velocity, pressure, direction of movement, rotational forces, turbulence, or the like) as the fluid mixture is directed through the second portion of the structure array toward the outlet of the housing.

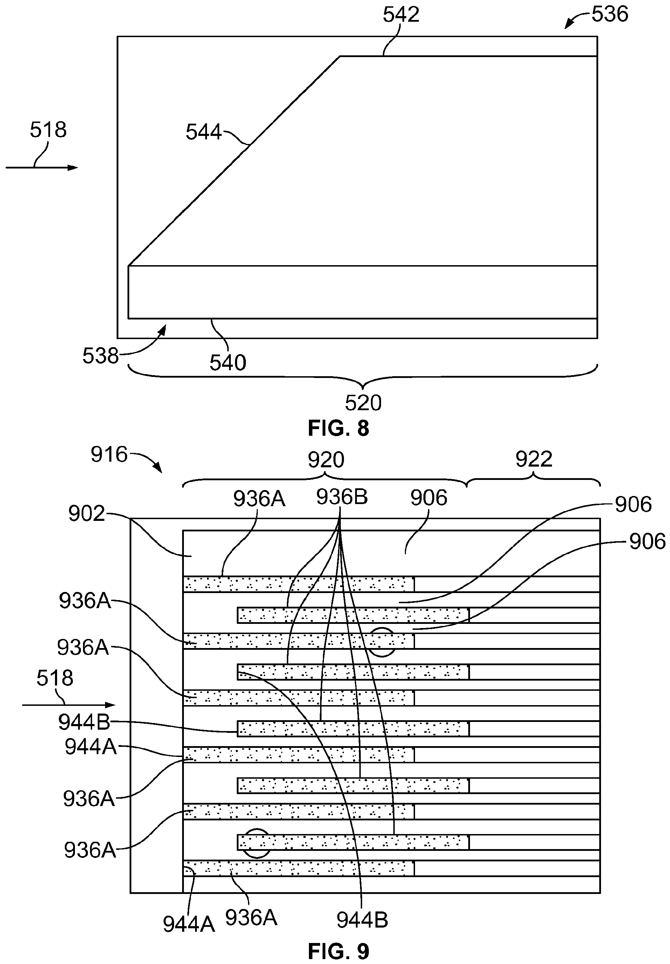

Figure 8 illustrates one example of a cross-sectional view of the first portion 520 of a structure 536 of the structure array in accordance with one embodiment. The structure includes a first surface 540 that is operably coupled with an internal surface 538 of the housing. In one embodiment, the first surface may be coupled with the internal surface via one or more coupling methods (e.g., welding, adhering, fastening, or the like), or alternatively the structure may be formed as a unitary structure or body with the internal surface of the housing. For example, the structure and the housing may be formed as a single structure by casting, printing, molding, or the like.

The structure includes the first surface that is coupled with the internal surface of the housing, and a second surface 542 that is disposed a distance away from the internal surface of the housing. In one embodiment, the second surface may be coupled with another internal surface of the housing. Optionally, the second surface may be disposed at a position within the cavity of the housing. Optionally, a portion of the second surface may be coupled with an internal surface of the housing (not shown) and another portion of the second surface may not be coupled with, or may be separated from an internal surface of the housing by a distance.

The structure includes an interference surface 544 that extends between the first and second surfaces of the structure. In the illustrated embodiment, a distance between the interference surface and the internal surface of the housing continuously increases at increasing distances in the direction of movement of the fluid mixture 518 (e.g., a first direction). Additionally, the interference surface is disposed at increasing distances away from the inlet of the housing. For example, the interference surface is an angled or an inclined surface relative to the internal surface of the housing and extends between the first and second surfaces of the structure. Optionally, the angled, inclined, or beveled surface of the interference surface may increase in a noncontinuous manner in the direction of movement of the fluid mixture. For example, the interference surface may include steps, waves, or the like.

In one or more embodiments, the first portion of the structure including the interference surface may be shaped to control an amount of debris that may be separated from the fluid. For example, the interference surface may be shaped to increase an amount of debris that is separated from the fluid within the first portion of the structure array. The first portion of the structure array may be shaped to control an amount of debris mixed with the fluid that is directed into the second portion of the structure array. For example, increasing the amount of debris separated from the fluid within the first portion of the structure array reduces an amount of debris that moves within the second portion of the structure array.

Figure 9 illustrates a top view of a structure array 916 of a fluid control device in accordance with one embodiment. The structure array includes a first portion 920 and a second portion 922 that is downstream of the first portion in the direction of movement of the fluid mixture 518 within the fluid control device. The structure array includes plural structures 936A, 936B. Each of the plural structures includes an interference surface 944A, 944B, respectively, that interferes with the fluid mixture to separate at least some of the debris from the fluid. The fluid mixture with the reduced amount of debris may move toward an outlet of the housing (not shown) through passages or conduits defined by adjacent structures.

In the illustrated embodiment, the interference surfaces 944A of the first structures 936A are linearly offset from the interference surfaces 944B of the second structures 936B. For example, the interference surfaces 944A of the first structures 936A are positioned at a first location (e.g., proximate to an inlet 902 of the fluid control device), and the interference surfaces 944B of the second structures 936B are positioned at a second location (e.g., a distance away from the inlet in the direction of movement of the fluid mixture) such that the adjacent first and second structures are staggered relative to each other. In the illustrated embodiment, each first structure is positioned adjacent to a second structure, and each first structure is linearly offset from each second structure. Optionally, the structure array may have structures disposed or positioned in an alternative patterned and/or random arrangement. Controlling the position of the interference surfaces of the different structures controls an amount of the fluid mixture that may be directed within passages between adjacent first structures, and within passages between adjacent first and second structures. In the illustrated embodiment, the first and second structures are positioned such that a width or space between each adjacent first and second structure within the structure array is substantially the same. Optionally, one or more structures may be positioned closer to or further away from adjacent structures such that a width or space between adjacent structures within the structure array is non-uniform.

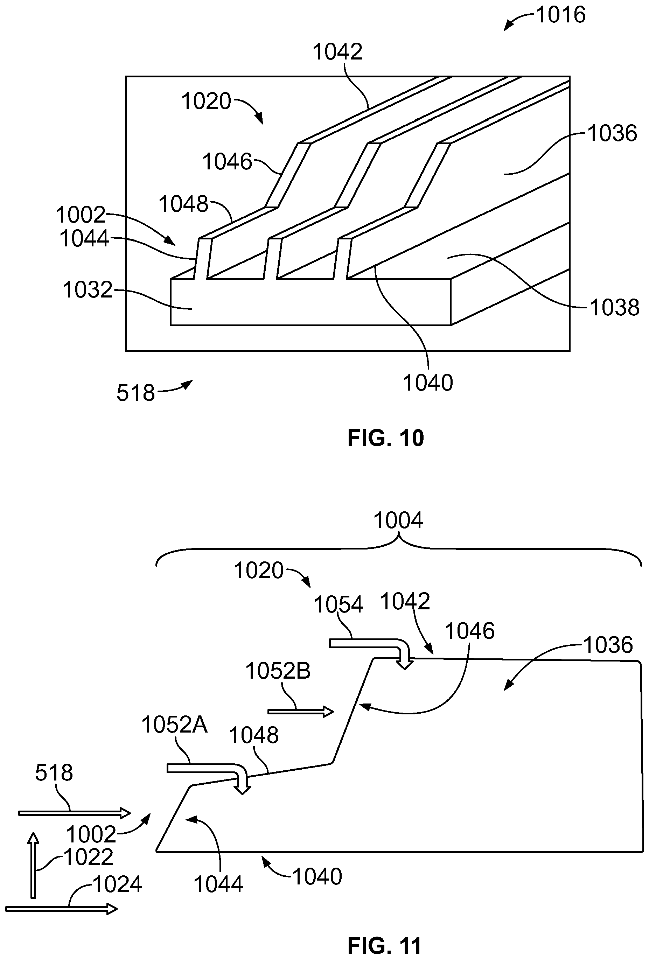

Figure 10 illustrates a partial perspective view of a structure array 1016 of a fluid control device in accordance with one embodiment. Figure 11 illustrates a side view of a structure 1036 of the structure array shown in Figure 10. A first portion 1004 of the structure array includes a step feature 1020. The step feature may be referred to as a beveled step, a bevel feature, inclined step, or the like. In the illustrated embodiment, each structure includes a first surface 1040 that is operably coupled with an internal surface 1038 of the housing. The structures also include a second surface 1042 disposed a distance away from the internal surface of the housing. The second surface is disposed a distance away from the internal surface of the housing in a first direction 1022, and a distance away from an inlet 1002 of the fluid control device in a second direction 1024.

The structures also include a third surface 1048 that is disposed between the first surface coupled with the internal surface of the housing and the second surface disposed a distance away from the internal surface. The structures include a first interference surface 1044 that extends between the first surface and the third surface, and a second interference surface 1046 that extends between the third surface and the second surface. For example, the two interference surfaces form the step feature of the first portion of the structure array. In the illustrated embodiment, the interference surfaces extend radially relative to the internal surface of the housing. For example, the interference surfaces are positioned at increasing distances away from the internal surface of the housing in the first direction 1022 and at increasing distances away from the inlet in the second direction 1024. Optionally, the interference surfaces may extend in a direction substantially perpendicular to the internal surface of the housing, or may extend in alternative radial directions relative to the internal surface of the housing.

In one or more embodiments, the first portion may include additionally surfaces disposed at different distances away from the internal surface, and additional interference surfaces extending therebetween to form a step feature having plural steps. In the illustrated embodiment of Figure 10, three structures are coupled with the internal surface of the housing, and the three structures have substantially similar step features. Optionally, the structure array may include any number of structures, and one or more of the structures may have a step feature that is different or unique relative to a step feature of another structure.

The step features included with each of the structures are shaped to control an amount of debris that is separated from the fluid, to control a direction of movement of the fluid mixture, and/or to control different locations within the first portion where different amounts of debris is separated from the fluid, and different locations where the fluid mixture (e.g., with a reduced amount of debris combined with the fluid) is directed toward the second portion of the structure array. For example, the fluid mixture is directed toward the first interference surface 1044. A portion of the debris is separated from the fluid responsive to the fluid mixture interfering with the first interference surface. A first portion 1052A of a first reduced fluid mixture (e.g., the first reduced fluid mixture has a reduced amount of debris relative to the fluid mixture that is directed into the fluid control device) is directed toward a passage or conduit formed between adjacent structures of the structure array in a direction away from the third surface of the step feature and toward the internal surface of the housing. Additionally, a second portion 1052B of the first reduced fluid mixture is directed toward the second interference surface 1046.

Another portion of the debris is separated from the fluid responsive to the second portion of the first reduced fluid mixture interfering with the second interference surface to create a second reduced fluid mixture 1054. The second reduced fluid mixture has an amount of debris combined with the fluid that is less than an amount of debris within the first reduced fluid mixture, and is less than an amount of debris within the fluid mixture. The second reduced fluid mixture is directed toward passages formed between adjacent structures of the structure array in a direction away from the second surface of the step feature and toward the internal surface of the housing. For example, the debris may collect onto the first and second interference surfaces, and the fluid combined with a reduced amount of debris may be allowed to move or flow between adjacent structures through the second portion of the structure array and toward an outlet of the fluid control device.

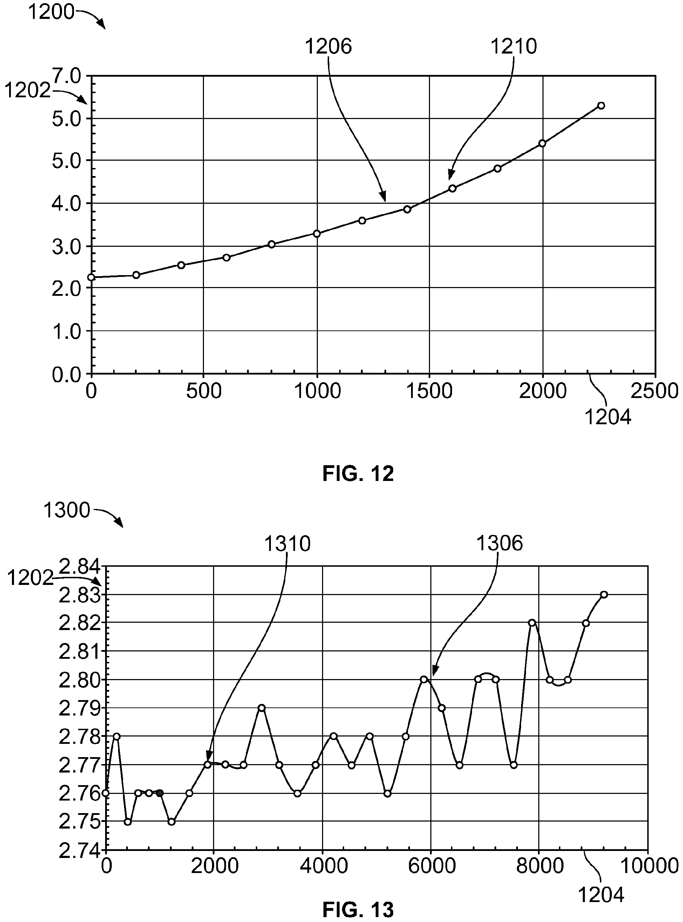

Figure 12 illustrates a performance graph 1200 of a system in accordance with one embodiment, such as the panel assembly. The graph includes a horizontal axis 1204 representative of an increasing amount of debris that moves through the system, and a vertical axis 1202 representative of a resistance of the fluid mixture as the fluid mixture moves within the system. For example, the resistance may indicate a change in pressure of the fluid mixture within the system, such as a pressure drop. The performance graph illustrated in Figure 12 may represent a performance of the fluid control device of the panel assembly illustrated in Figures 1 and 2. For example, the system may include a panel and a fluid control device, where the panel includes passages disposed between side surfaces of the panel and side surfaces of the fluid control device. Additionally, the fluid control device may be a single pass fluid control device. A data line 1206 indicates an increasing resistance at increasing amounts or quantities of debris combined with the fluid. A data point 1210 indicates about a 200% increase in pressure drop in the fluid control device after about 1600 grams of debris is directed into the fluid control device.

Alternatively, Figure 13 illustrates a performance graph of another system in accordance with one embodiment. The graph includes the horizontal axis 1204 representative of the increasing amount of debris that moves through the system, and the vertical axis 1202 representative of a resistance of the fluid mixture as the fluid mixture moves within the system. For example, the resistance may indicate a pressure drop of the fluid mixture within the system. The graph illustrated in Figure 13 may represent a performance of the fluid control device of the panel assembly shown in Figures 5 through 7. For example, the system may include a panel and a fluid control device, where the inlet of the fluid control device extends a width that is substantially the same as the width of the housing of the fluid control device. Additionally, the fluid mixture may move in a passage that has a width that is about the same as the width of the housing, such that the volume of the fluid mixture that moves toward the inlet of the fluid control device is distributed (substantially evenly or unevenly) along the width of the inlet.

The graph includes a data line 1306 that indicates increasing resistance at increasing amounts or quantities of debris. A data point 1310 indicates about 1600 grams of debris that is directed into and through the fluid control device. Unlike the performance graph illustrated in Figure 12, the data point 1310 illustrated in Figure 13 indicates that there is substantially no pressure drop (e.g., a minimal change in the resistance) after about 1600 grams of debris is introduced into the fluid control device. For example, the change in resistance from zero grams of debris to about 1600 grams of debris is less than 0.5%. Additionally, the change in resistance from about zero grams to about 8000 grams of debris is less than 5%. For example, the fluid mixture moving through the fluid control device illustrated in Figures 5 through 7 had a reduced pressure drop relative to the fluid mixture moving through the fluid control device illustrated in Figures 1 and 2. In one or more embodiments, the reduced pressure drop of the fluid mixture moving within the fluid control device illustrated in Figures 5 through 7 may indicate a reduced amount of clogging of debris within the housing relative to the fluid control device shown in Figures 1 and 2.

In one or more embodiments, a fluid control device includes a housing having plural surfaces defining a cavity within the housing. The housing includes an inlet configured to receive a fluid mixture and an outlet configured to direct the fluid mixture out of the housing. The fluid mixture includes a fluid combined with debris. A structure array is disposed within the cavity of the housing and includes plural structures. Each of the plural structures includes a first surface operably coupled with an internal surface of the housing and a second surface disposed a distance away from the internal surface of the housing. The structure array includes a first portion and a second portion. The first portion of the structure array is configured to interfere with the fluid mixture to separate at least some of the debris from the fluid, and the second portion of the structure array is configured to direct the fluid and at least some of the debris toward the outlet.

Optionally, the fluid and the at least some of the debris may move through the second portion of the structure array toward the outlet between adjacent structures of the plural structures of the structure array.

Optionally, a shape of the first portion of the structure array may be different than a shape of the second portion of the structure array.

Optionally, one or more of the plural structures of the structure array may include two or more interference surfaces forming a step feature of the first portion of the structure array.

Optionally, the two or more interference surfaces forming the step feature may be operably coupled together via a third surface of the one or more of the plural structures.

Optionally, the third surface may be disposed between the first surface operably coupled with the internal surface of the housing and the second surface disposed the distance away from the internal surface of the housing.

Optionally, each of the plural structures of the structure array may include an interference surface. The interference surface of one or more of the plural structures may be angled relative to the internal surface of the housing.

Optionally, the interference surface of a first structure of the plural structures may be linearly offset from the interference surface of a second structure of the plural structures. The first structure may be adjacent to the second structure.

Optionally, the second portion of the structure array may be downstream from the first portion of the structure array in a direction of movement of the fluid mixture.

Optionally, the housing may be fluidly coupled with a passage configured to direct the fluid mixture toward the inlet of the housing. The passage may be configured to direct the fluid mixture to move in a first direction within the passage, and the cavity may be configured to direct the fluid mixture to move in a different, second direction within the cavity.

Optionally, the inlet of the housing may be fluidly coupled with the passage. The inlet of the housing may extend between a first end and a second end of the housing, and the passage may extend between the first end and the second end of the housing.

Optionally, the housing may be operably coupled with a vehicle system. The fluid mixture may control a temperature of the vehicle system as the fluid mixture moves within the housing.

Optionally, the housing may have a width between a first end and a second end of the housing. The inlet may extend between the same width between the first end and the second end of the housing.

In one or more embodiments, a method includes directing a fluid mixture having a fluid combined with debris into a housing via an inlet. The housing includes plural surfaces defining a cavity within the housing. At least some of the debris is separated from the fluid with a first portion of a structure array disposed within the cavity as the fluid mixture moves within the first portion of the structure array. The structure array includes plural structures, and each of the plural structures includes an interface surface, a first surface operably coupled with an internal surface of the housing, and a second surface disposed a distance away from the internal surface of the housing. The fluid and at least some of the debris is directed through a second portion of the structure array toward an outlet of the housing.

Optionally, the second portion of the structure array may be downstream of the first portion of the structure array in a direction of movement of the fluid mixture within the housing.

Optionally, the method may include directing the fluid mixture in a first direction within a passage fluidly coupled with the housing, and directing the fluid mixture in a different, second direction within the cavity.

In one or more embodiments, a system includes a fluid control device having a housing that includes plural surfaces defining a cavity within the housing. The housing includes an inlet configured to receive a fluid mixture and an outlet configured to direct the fluid mixture out of the housing. The inlet of the housing extends between a first end and a second end of the housing. The fluid mixture includes a fluid combined with debris. The fluid control device includes a structure array disposed within the cavity of the housing that includes a first portion and a second portion. The first portion of the structure array is configured to interfere with the fluid mixture to separate at least a portion of the debris from the fluid, and the second portion of the structure array is configured to direct the fluid and a portion of the debris toward the outlet. The system includes a passage fluidly coupled with the fluid control device. The passage extends between a passage inlet and a passage outlet. The passage outlet is fluidly coupled with the inlet of the housing. The passage outlet extends between the first end and the second end of the housing. The fluid mixture is configured to move in a first direction within the passage and the fluid mixture is configured to move in a different, second direction within the cavity.

Optionally, the structure array may include plural structures, each of the plural structures including an interference surface, a first surface operably coupled with an internal surface of the housing, and a second surface disposed a distance away from the internal surface of the housing. The interference surface of one or more of the plural structures may be angled relative to the internal surface of the housing.

Optionally, the interference surface of a first structure of the plural structures may be linearly offset from the interference surface of a second structure of the plural structures.

Optionally, one or more of the plural structures of the structure array may include two or more interference surfaces forming a step feature of the first portion of the structure array. The two or more interference surfaces forming the step feature may be operably coupled together via a third surface of the one or more of the plural structures. The third surface may be disposed between the first surface operably coupled with the internal surface of the housing and the second surface disposed a distance away from the internal surface of the housing.

As used herein, the terms "processor" and "computer," and related terms, e.g., "processing device," "computing device," and "controller" may be not limited to just those integrated circuits referred to in the art as a computer, but refer to a microcontroller, a microcomputer, a programmable logic controller (PLC), field programmable gate array, and application specific integrated circuit, and other programmable circuits. Suitable memory may include, for example, a computer-readable medium. A computer-readable medium may be, for example, a random-access memory (RAM), a computer-readable non-volatile medium, such as a flash memory. The term "non-transitory computer-readable media" represents a tangible computer-based device implemented for short-term and long-term storage of information, such as, computer-readable instructions, data structures, program modules and sub-modules, or other data in any device. Therefore, the methods described herein may be encoded as executable instructions embodied in a tangible, non-transitory, computer-readable medium, including, without limitation, a storage device and/or a memory device. Such instructions, when executed by a processor, cause the processor to perform at least a portion of the methods described herein. As such, the term includes tangible, computer-readable media, including, without limitation, non-transitory computer storage devices, including without limitation, volatile and non-volatile media, and removable and non-removable media such as firmware, physical and virtual storage, CD-ROMS, DVDs, and other digital sources, such as a network or the Internet.

The singular forms "a", "an", and "the" include plural references unless the context clearly dictates otherwise. "Optional" or "optionally" means that the subsequently described event or circumstance may or may not occur, and that the description may include instances where the event occurs and instances where it does not. Approximating language, as used herein throughout the specification and claims, may be applied to modify any quantitative representation that could permissibly vary without resulting in a change in the basic function to which it may be related. Accordingly, a value modified by a term or terms, such as "about," "substantially," and "approximately," may be not to be limited to the precise value specified. In at least some instances, the approximating language may correspond to the precision of an instrument for measuring the value. Here and throughout the specification and claims, range limitations may be combined and/or interchanged, such ranges may be identified and include all the sub-ranges contained therein unless context or language indicates otherwise.

This written description uses examples to disclose the embodiments, including the best mode, and to enable a person of ordinary skill in the art to practice the embodiments, including making and using any devices or systems and performing any incorporated methods. The claims define the patentable scope of the disclosure, and include other examples that occur to those of ordinary skill in the art. Such other examples are intended to be within the scope of the claims if they have structural elements that do not differ from the literal language of the claims, or if they include equivalent structural elements with insubstantial differences from the literal language of the claims.

## Claims

1. A fluid control device comprising:
a housing comprising plural surfaces defining a cavity within the housing, the housing comprising an inlet configured to receive a fluid mixture and an outlet configured to direct the fluid mixture out of the housing, the fluid mixture comprising a fluid combined with debris; and
a structure array disposed within the cavity of the housing, the structure array comprising plural structures, each of the plural structures having a first surface operably coupled with an internal surface of the housing and a second surface disposed a distance away from the internal surface of the housing, the structure array comprising a first portion and a second portion,
wherein the first portion of the structure array is configured to interfere with the fluid mixture to separate at least some of the debris from the fluid, and the second portion of the structure array configured to direct the fluid and at least some of debris toward the outlet.

2. The fluid control device of claim 1, wherein the fluid and the at least some of the debris is configured to move through the second portion of the structure array toward the outlet between adjacent structures of the plural structures of the structure array.

3. The fluid control device of claim 1, wherein a shape of the first portion of the structure array is different than a shape of the second portion of the structure array.

4. The fluid control device of claim 1, wherein one or more of the plural structures of the structure array includes two or more interference surfaces forming a step feature of the first portion of the structure array.

5. The fluid control device of claim 4, wherein the two or more interference surfaces forming the step feature are operably coupled together via a third surface of the one or more of the plural structures.

6. The fluid control device of claim 5, wherein the third surface is disposed between the first surface operably coupled with the internal surface of the housing and the second surface disposed the distance away from the internal surface of the housing.

7. The fluid control device of claim 1, wherein each of the plural structures of the structure array includes an interference surface, wherein the interference surface of one or more of the plural structures is angled relative to the internal surface of the housing.

8. The fluid control device of claim 7, wherein the interference surface of a first structure of the plural structures is linearly offset from the interference surface of a second structure of the plural structures, wherein the first structure is adjacent to the second structure.

9. The fluid control device of claim 1, wherein the second portion of the structure array is downstream from the first portion of the structure array in a direction of movement of the fluid mixture.

10. The fluid control device of claim 1, wherein the housing is fluidly coupled with a passage configured to direct the fluid mixture toward the inlet of the housing, wherein the passage is configured to direct the fluid mixture to move in a first direction within the passage, and the cavity is configured to direct the fluid mixture to move in a different, second direction within the cavity.

11. The fluid control device of claim 10, wherein the inlet of the housing is fluidly coupled with the passage, wherein the inlet of the housing extends between a first end and a second end of the housing, and the passage extends between the first end and the second end of the housing.

12. The fluid control device of claim 1, wherein the housing is operably coupled with a vehicle system, the fluid mixture configured to control a temperature of the vehicle system as the fluid mixture moves within the housing.

13. The fluid control device of claim 1, wherein the housing has a width between a first end and a second end of the housing, wherein the inlet extends between the same width between the first end and the second end of the housing.

14. A method comprising:
directing a fluid mixture comprising a fluid combined with debris into a housing via an inlet, the housing comprising plural surfaces defining a cavity within the housing,
separating at least some of the debris from the fluid with a first portion of a structure array disposed within the cavity as the fluid mixture moves within the first portion of the structure array, the structure array comprising plural structures, each of the plural structures having an interference surface, a first surface operably coupled with an internal surface of the housing, and a second surface disposed a distance away from the internal surface of the housing; and
directing the fluid and at least some of the debris through a second portion of the structure array toward an outlet of the housing.

15. A system comprising:
a fluid control device comprising:
a housing including plural surfaces defining a cavity within the housing, the housing comprising an inlet configured to receive a fluid mixture and an outlet configured to direct the fluid mixture out of the housing, the inlet of the housing extending between a first end and a second end of the housing, the fluid mixture comprising a fluid combined with debris; and
a structure array disposed within the cavity of the housing comprising a first portion and a second portion, wherein the first portion of the structure array is configured to interfere with the fluid mixture to separate at least a portion of the debris from the fluid, and the second portion of the structure array configured to direct the fluid and a portion of debris toward the outlet; and
a passage fluidly coupled with the fluid control device, the passage extending between a passage inlet and a passage outlet, wherein the passage outlet is fluidly coupled with the inlet of the housing, wherein the passage outlet extends between the first end and the second end of the housing,
wherein the fluid mixture is configured to move in a first direction within the passage and the fluid mixture is configured to move in a different, second direction within the cavity.
